# EUROPEAN PATENT APPLICATION

(11) **EP 4 636 450 A2**
(43) Date of publication of application: **22.10.2025**
(21) Application number: 25167605.2
(22) Date of filing: 01.04.2025
(51) Int. Cl.: G02B 6/42, G02B 6/43, H01L 25/16, H05K 1/18

(54) **DUAL-SIDED ELECTRO-OPTICAL ASSEMBLY**

(30) Priority: 18.04.2024 US 202463635992 P; 19.02.2025 US 202519056655
(71) Applicant: Cisco Technology, Inc., San Jose, CA 95134-1706 (US)
(72) Inventor: Achkir, Brice, San Jpse, 95134-1706 (US); Schlepple, Norbert, San Jose, 95134-1706 (US); Patel, Vipul, San Jose, 95134-1706 (US)
(74) Representative: Noble, Nicholas

(57) **Abstract**

Electro-optical assemblies are disclosed. In one aspect, an electro-optical assembly includes a substrate having a first side and a second side opposing the first side. The electro-optical assembly also includes an optical engine (OE) coupled with the first side of the substrate. The electro-optical assembly further includes a serializer/deserializer (SerDes) coupled with the second side of the substrate, as well as an integrated circuit (IC) coupled with the second side of the substrate. The IC is electrically coupled with the SerDes. The OE is electrically coupled with the SerDes by way of a signal channel that traverses through the substrate between the first side and the second side.

## Description

### CROSS-REFERENCE TO RELATED APPLICATIONS

This application claims benefit of co-pending United States provisional patent application Serial No. 63/635,992 filed April 18, 2024.

### TECHNICAL FIELD

Embodiments presented in this disclosure generally relate to electro-optical assemblies, such as co-packaged optics (CPO) and near-packaged optics (NPO) assemblies.

### BACKGROUND

Co-packaged optics (CPO) and near-packaged optics (NPO) represent a transformative leap in data center technology, addressing the escalating needs for bandwidth and power efficiency. By integrating optical interfaces with switch silicon or bringing them closer to silicon, CPO and NPO offer a scalable solution that enhances performance while significantly cutting energy use.

While CPO and NPO are some of the implementations that bring optical engines (OE) and electrical/optical conversion closer to a switch application-specific integrated circuit (ASIC), a co-planar arrangement of OEs surrounding the ASIC means highspeed connections between the OEs and the ASIC are still several tens of millimeters long and consume significant bandwidth and power due to boosting needed from the SerDes to compensate for the impairments caused by the routing challenges. Stress and warpage can limit how large the substrate upon which the ASIC, SerDes, and OEs are mounted can be made and hence any designs that can reduce size/balance the stress are desirable.

### BRIEF DESCRIPTION OF THE DRAWINGS

So that the manner in which the above-recited features of the present disclosure can be understood in detail, a more particular description of the disclosure, briefly summarized above, may be had by reference to embodiments, some of which are illustrated in the appended drawings. It is to be noted, however, that the appended drawings illustrate typical embodiments and are therefore not to be considered limiting; other equally effective embodiments are contemplated.
FIG. 1A depicts a schematic side cross-sectional view of an electro-optical assembly according to one or more aspects of the present disclosure.
FIG. 1B depicts a perspective view of a first side of the electro-optical assembly of FIG. 1A.
FIG. 1C depicts a perspective view of a second side of the electro-optical assembly of FIG. 1A.
FIGS. 2A and 2B depict schematic side cross-sectional views of electro-optical assemblies having optical engines arranged within cutouts defined by printed circuit boards according to one or more aspects of the present disclosure.
FIGS. 3A through 3E depict schematic side cross-sectional views of electro-optical assemblies each having an access clearance for optical engines according to one or more aspects of the present disclosure.
FIG. 4 depicts a schematic side cross-sectional view of an electro-optical assembly having an optically-enabled substrate according to one or more aspects of the present disclosure.
FIG. 5 depicts a schematic side cross-sectional view of an electro-optical assembly according to one or more aspects of the present disclosure.
FIG. 6 depicts a top view of an electro-optical assembly according to one or more aspects of the present disclosure.
To facilitate understanding, identical reference numerals have been used, where possible, to designate identical elements that are common to the figures. It is contemplated that elements disclosed in one embodiment may be beneficially used in other embodiments without specific recitation.

### DESCRIPTION OF EXAMPLE EMBODIMENTS

### OVERVIEW

In one aspect, an electro-optical assembly is provided. The electro-optical assembly includes a substrate having a first side and a second side opposing the first side. The electro-optical assembly also includes an optical engine (OE) coupled with the first side of the substrate. The electro-optical assembly further includes a serializer/deserializer (SerDes) coupled with the second side of the substrate. The electro-optical assembly also includes an integrated circuit (IC) coupled with the second side of the substrate, the IC being electrically coupled with the SerDes. The OE is electrically coupled with the SerDes by way of a signal channel that traverses, at least in part, through the substrate between the first side and the second side.

In another aspect, an electro-optical assembly is provided. The electro-optical assembly includes a printed circuit board (PCB); a substrate mounted to the PCB; an optical engine (OE); a serializer/deserializer (SerDes); and an integrated circuit (IC) electrically coupled with the SerDes. The IC and SerDes are arranged on a same side of the substrate opposite a side to which the OE is arranged. The OE is electrically coupled with the SerDes by way of a signal channel that traverses through the substrate and electrical power is supplied to the IC by way of a power channel that traverses from the PCB to the IC and extends through the substrate. The signal channel and the power channel are separate channels.

In yet another aspect, an electro-optical assembly is provided. The electro-optical assembly includes a substrate having a first side and a second side opposing the first side. The electro-optical assembly also includes a printed circuit board (PCB) having a first PCB side and a second PCB side opposing the first PCB side, the first PCB side being coupled with the first side of the substrate. Further, the electro-optical assembly includes an optical engine (OE) coupled with the second PCB side, the PCB being arranged between the substrate and the OE. Also, the electro-optical assembly includes a serializer/deserializer (SerDes) coupled with the second side of the substrate. The electro-optical assembly further includes an integrated circuit (IC) coupled with the second side of the substrate, the IC being electrically coupled with the SerDes. The OE is electrically coupled with the SerDes by way of a signal channel that traverses, at least in part, through the PCB between the first PCB side and the second PCB side and through the substrate between the first side and the second side.

### EXAMPLE EMBODIMENTS

Disclosed herein are various dual-sided electro-optical assemblies. In one or more examples, an electro-optical assembly can include a substrate, one or more optical engines (OEs), an integrated circuit (IC) (e.g., a switch application-specific integrated circuit (ASIC)), and a plurality of serializer/deserializers (SerDes). The electro-optical assembly can be a "dual-sided" electro-optical assembly in that the OEs can be arranged on an opposite side of the substrate from the IC and the SerDes. Stated another way, the OEs and the IC/SerDes can be coupled with opposite sides of the substrate. In this regard, the OEs and IC/SerDes are not co-planar, but rather, they are spaced from one another at least by the thickness of the substrate. The OEs can be electrically coupled with the SerDes by way of highspeed signal channels that traverse through the thickness of the substrate. The SerDes can be electrically coupled with the IC by way of electrical traces. In this way, optical signals can be received at the OEs, which can include features for converting the optical signals into electrical signals. The electrical signals can be routed along the highspeed signals channels through the thickness of the substrate to the SerDes, and eventually to the IC. Signals can also travel in an opposite direction along these signal paths.

Advantageously, the architecture of the disclosed dual-sided electro-optical assemblies can allow the OEs to be placed closer to the substrate center (or center of the IC if the IC is not centered on the substrate), which can minimize or reduce the electrical highspeed path lengths from the OEs to the SerDes. The minimized or reduced highspeed path lengths can reduce loss and power dissipation and can increase signal integrity. Moreover, additional benefits can include increased freedom in SerDes placement relative to the IC (e.g., by using a strategically arranged thin routing film) as well as new ways to route and aggregate optical highspeed signals, either within the substrate or within a printed circuit board (PCB) to which the substrate is mounted. Also, as the OEs are placed on an opposing side of the substrate relative to the IC and SerDes, the substrate thickness and/or footprint can be reduced as these components can be co-packaged more compactly. As a further advantage, arranging the OEs and the IC/SerDes on opposing sides of the substrate can counterbalance the stress and/or warpage on the substrate, providing enhanced structural integrity to the package.

Further, the dual-sided electro-optical assemblies disclosed herein can allow for OEs to have their own OE substrates attached via ball grid array (BGA) or land grid array (LGA) to the substrate, or alternatively, the chipsets of the OEs can be directly attached to the substrate (i.e., without their own OE substrates). Also, the dual-sided electro-optical assemblies disclosed herein can allow for an OE access clearance to be defined between the substrate and a PCB to which the substrate is mounted. This clearance can provide both mechanical clearance and/or optical and/or thermal routing. Moreover, the dual-sided electro-optical assemblies disclosed herein can include a PCB that defines cutouts in which the OEs can be disposed, which can reduce the overall height of the package and provide readily available access to the OEs. In addition, the coupling of optical signals from the OEs to the PCB (or optical layer disposed on the PCB) can be realized with the dual-sided electro-optical assemblies disclosed herein, e.g., using an optically-enabled PCB and/or an optical layer attached to the PCB and having optical circuitry. In one or more further examples, the dual-sided electro-optical assemblies disclosed herein can include an optically-transparent glass substrate that carries optical functionalities, such as passive optical waveguides connecting the OEs and an optical connector at a substrate edge, as well as additional optical elements such as demultiplexers, splitters, etc. for optical channel disaggregation. In one or more other examples, the dual-sided electro-optical assemblies disclosed herein can include OEs attached to a PCB backside, connecting the OEs and SerDes using via stacks through both the PCB and the substrate.

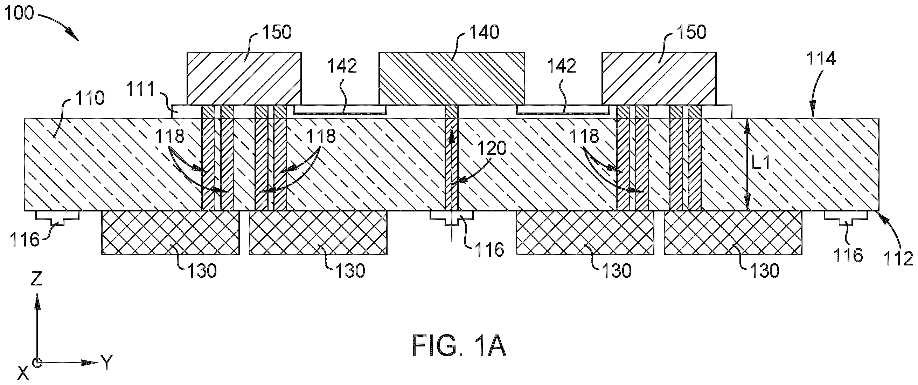

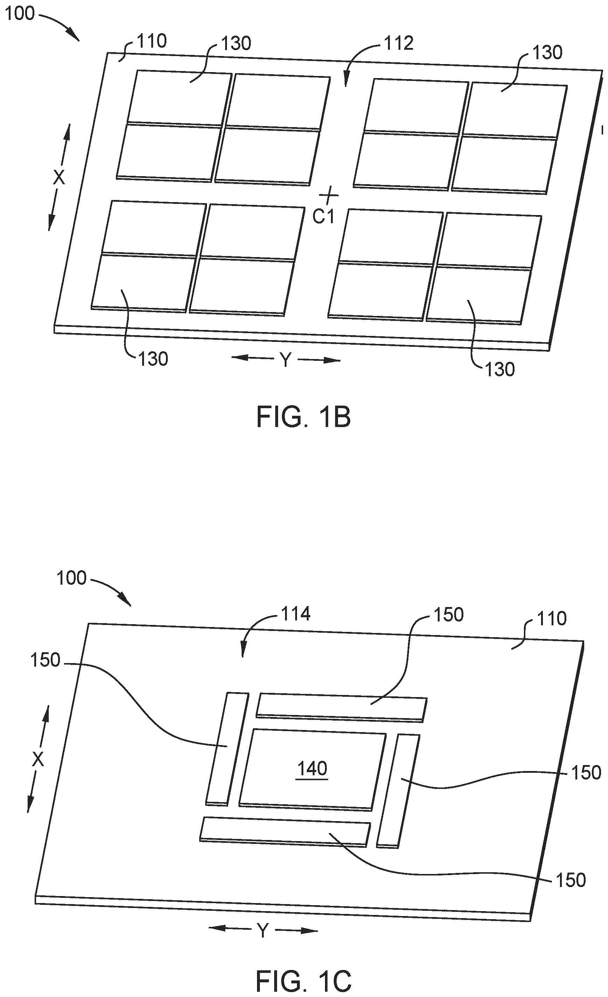

With reference now to FIGS. 1A, 1B, and 1C, an electro-optical assembly 100 according to one or more aspects of the present disclosure will be provided. FIG. 1A depicts a schematic side cross-sectional view of the electro-optical assembly 100. FIG. 1B depicts a perspective view of a first side of the electro-optical assembly 100. FIG. 1C depicts a perspective view of a second side of the electro-optical assembly 100. For reference, the electro-optical assembly 100 can define an X-direction, a Y-direction, and a Z-direction, which are mutually perpendicular to one another. In one or more examples, the X-direction can be a traverse direction, the Y-direction can be a lateral direction, and the Z-direction can be a vertical direction.

The electro-optical assembly 100 can include a substrate 110 having a first side 112 and a second side 114 opposing the first side 112. In the depicted example of FIG. 1A, the first side 112 is a back or bottom side and the second side 114 is a top side of the substrate 110. A plurality of mating structures 116 can be coupled with the first side 112 of the substrate 110. The mating structures 116 can be connectable with corresponding mating structures, e.g., coupled with a printed circuit board (PCB). When the mating structures 116 are connected with corresponding mating structures, e.g., of a PCB, the substrate 110 and the PCB (or other component to which the corresponding mating structures are coupled) can be electrically and mechanically coupled with one another. In at least one example, the mating structures 116 can be socket connectors (e.g., male socket connectors) and the corresponding mating structures can be socket connectors (e.g., female socket connectors or receptacles).

The electro-optical assembly 100 can also include one or more optical engines (OEs), or OEs 130. The OEs 130 can be optical transceivers, for example. In one or more examples, the OEs 130 can each include chipsets that include at least a photonic chip having a photonic integrated circuit (PIC) and an electronic chip having an electrical integrated circuit (EIC). The OEs 130 can be arranged to convert optical signals into electrical signals as well as electrical signals into optical signals. As shown in FIG. 1B, the electro-optical assembly 100 includes four (4) sets of four (4) OEs 130 for a total of sixteen (16) OEs. In other examples, the electro-optical assembly 100 can include more or less than sixteen (16) OEs. The OEs 130 can be coupled with the first side 112 of the substrate 110. In the illustrated example of FIGS. 1A, 1B, and 1C, the OEs 130 are directly coupled with the first side 112 of the substrate 110 (e.g., directly attached to the first side 112 of the substrate 110, such as by bonding). In other examples, the OEs 130 can be indirectly coupled with the substrate 110, e.g., with one or more intermediate components positioned therebetween.

The electro-optical assembly 100 can also include an integrated circuit (IC), or IC 140. The IC 140 can be an application-specific integrated circuit (ASIC), such as a network processing unit (NPU) or switch ASIC, for example. The IC 140 can be coupled with the second side 114 of the substrate 110, or rather, coupled with the side of the substrate 110 opposite to which the OEs 130 are coupled. The IC 140 can be directly or indirectly coupled with the second side 114 of the substrate 110. Moreover, the IC 140 can be centrally located on the substrate 110, e.g., as shown in FIG. 1C. However, other locations are contemplated.

The electro-optical assembly 100 can further include one or more serializer/deserializers (SerDes), or SerDes 150. As shown in FIG. 1C, the electro-optical assembly 100 includes four (4) SerDes. In other examples, the electro-optical assembly 100 can include more or less than four (4) SerDes. The SerDes 150 can be arranged about the IC 140 so that each edge of the IC 140 is spaced from one of the SerDes 150. In at least one example, each edge of the IC 140 can face a different one of the SerDes 150. The SerDes 150 are arranged to convert parallel data to serial data, and vice versa.

The SerDes 150 can be coupled with the second side 114 of the substrate 110, or rather, coupled with the side of the substrate 110 opposite to which the OEs 130 are coupled. In this way, the OEs 130 and the IC 140/SerDes 150 are arranged on opposite sides of the substrate 110, while the SerDes 150 and the IC 140 are arranged on a same side of substrate 110. Thus, the electro-optical assembly 100 can be considered a dual-sided co-packaged optics assembly.

In the illustrated example of FIGS. 1A, 1B, and 1C, the SerDes 150 are indirectly coupled with the substrate 110, e.g., with a thin routing film 111 being positioned therebetween. As depicted in FIG. 1A, the SerDes 150 and the IC 140 are mounted to the thin routing film 111, and the thin routing film 111 is arranged between the SerDes 150 and the substrate 110 and between the IC 140 and the substrate 110, e.g., along the Z-direction. The thin routing film 111 can include electrical traces 142 that electrically couple the SerDes 150 with the IC 140. In this way, the IC 140 can be electrically coupled with each one of the SerDes 150. The thin routing film 111 can advantageously provide flexibility in the spacing between IC 140 and the SerDes 150, e.g., along the X-direction and the Y-direction. In other examples, the SerDes 150 can be directly coupled with the second side 114 of the substrate 110 (e.g., directly attached to the second side 114 of the substrate 110, such as by bonding). In such examples, the SerDes 150 can be electrically coupled with the IC 140 by way of electrical traces that traverse through, or run on, the substrate 110.

As illustrated in FIG. 1A, the OEs 130 can be electrically coupled with the SerDes 150 by way of signal channels 118 that traverse, at least in part, through the substrate 110 between the first side 112 and the second side 114. The signal channels 118 can be high speed signal paths optimized for signal integrity, for example. Accordingly, electrical signals can travel along the signal channels 118 through at least the thickness of the substrate 110 (the dimension along the Z-direction in this example) between the OEs 130 and the SerDes 150. In this example, the signal channels 118 extend through the thickness of the substrate 110 and through the thickness of the thin routing film 111. In at least one example, each one of the OEs 130 is electrically coupled with at least one of the SerDes 150 by one or more of the signal channels 118.

In one or more examples, at least one of the signal channels 118, or a portion thereof, has a length L1 extending between the first side 112 and the second side 114 of the substrate 110. The at least one channel, or portion thereof, can extend substantially vertically along an entirety of the length L1, e.g., as shown in FIG. 1A. In this regard, the at least one channel, or portion thereof, can extend between one of the OEs 130 and one of the SerDes 150 in a straight line, e.g., without a horizontal transition. As used herein, "substantially vertically" means at least within 10 degrees (10°) of parallel to the Z-direction.

In one or more examples, one or more of the OEs 130 can be arranged, at least in part, underneath one of the SerDes 150. Stated another, one or more of the OEs 130 can be aligned, at least in part, with one of the SerDes 150 along the X-direction and the Y-direction (but yet spaced from one another along the Z-direction as shown in FIG. 1A). In this way, the signal channel 118 extending between an OE and a SerDes can extend in a straight line, as noted above, which can minimize the signal path length. In at least one example, multiple OEs 130 can be located, at least in part, underneath one of the SerDes 150. In yet other examples, each one of the OEs 130 can be located underneath one of the SerDes 150.

In one or more examples, electrical power can be supplied to the IC 140 by way of a power channel 120. The power channel 120 can be a lower speed channel than the signal channels 118. The power channel 120 can traverse, at least in part, through the substrate 110 between the first side 112 and the second side 114. In this example, the power channel 120 extends through the thickness of the substrate 110 and through the thickness of the thin routing film 111. In one or more examples, the power channel 120, or portion thereof, can traverse through the substrate 110 in a straight line, e.g., without a horizontal transition. In at least one example, the power channel 120 can be arranged underneath the IC 140, e.g., as shown in FIG. 1A. When the mating structure 116 associated with the power channel 120 is connected with a corresponding mating structure, e.g., of a PCB, electrical power can be supplied to the IC 140 by way of the power channel 120. Accordingly, the electro-optical assembly 100 enables power and high speed electrical signals to traverse through the substrate 110 in separate and dedicated channels.

The architecture of the electro-optical assembly 100 can provide one or more advantages, benefits, and/or technical effects. For instance, by arranging the OEs 130 on an opposite side of the substrate 110 from the SerDes 150 and the IC 140, the length of the signal channels 118 can be minimized or reduced, which results in less transmission loss and increased signal integrity. In at least one example, by placing the OEs 130 and the SerDes 150/IC 140 on opposite sides of the substrate 110, the OEs 130 can be placed closer to a center C1 (FIG. 1B) of the substrate 110, or rather, closer the centrally located IC 140 and surrounding SerDes 150. This can not only allow for the highspeed electrical path lengths to be minimized, the size of the substrate 110 can be reduced as the OEs 130 can be more tightly packaged toward the center C1. Moreover, the thin routing film 111 can allow for flexibility in the spacing of the SerDes 150 relative to the IC 140, which can allow for optimum or more optimal placement of the OEs relative to the SerDes 150. Moreover, highspeed connections between the substrate 110 and a PCB can be eliminated or reduced, allowing the PCB to be attached to the substrate by way of connectors or sockets.

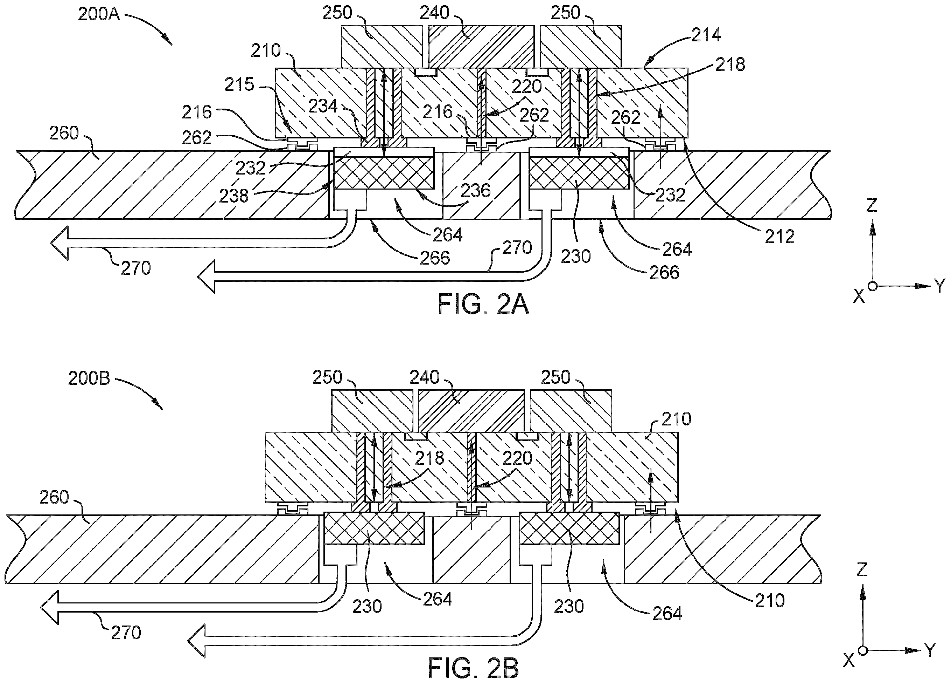

FIG. 2A depicts a schematic side cross-sectional view of an electro-optical assembly 200A according to one or more aspects of the present disclosure. The electro-optical assembly 200A of FIG. 2A is configured in a similar manner as the electro-optical assembly 100 described above.

As shown in FIG. 2, the electro-optical assembly 200A can include a substrate 210 having a first side 212 and a second side 214 opposing the first side 212. The first side 212 can be a bottom or back side and the second side 214 can be a top side. The electro-optical assembly 200A can also include OEs 230 coupled with the first side 212 of the substrate 210. In this example, the OEs 230 each have an OE substrate 232 that is bonded to the second side 214, e.g., by way of one or more solder bumps 234. The OEs 230 can each be arranged to have a chipset that includes an electrical chip bonded to the OE substrate 232 and a photonic chip bonded to the electrical chip. In this way, the electrical chip can be arranged between the OE substrate 232 and the photonic chip, e.g., along the Z-direction. The electro-optical assembly 200A can also include a plurality of SerDes 250 and an IC 240 coupled with the second side 214 of the substrate 210. The IC 240 can be electrically coupled with each of the SerDes 250. The OEs 230 and the IC 240 and SerDes 250 are coupled with the substrate 210 on opposite sides. The IC 240 can be an NPU or other type of ASIC, for example.

In the illustrated example of FIG. 2, the electro-optical assembly 200A can further include a PCB 260. The substrate 210 can be mounted to the PCB 260. For instance, the substrate 210 can include a plurality of mating structures 216 that are connectable with corresponding ones of a plurality of mating structures 262 of the PCB 260. When the mating structures 216 are connected with their corresponding mating structures 262, interconnects 215 can be formed that electrically and mechanically couple the PCB 260 with the substrate 210. Further, in the example of FIG. 2, the PCB 260 defines cutouts 264 in which the OEs 230 are disposed. In this way, optical fibers 270 can be coupled with respective ones of the OEs 230. The optical fibers 270 can extend through respective bottom openings 266 of the cutouts 264 and upward to their respective OEs 230.

In at least one example, the optical fibers 270 can be surface coupled to respective bottom surfaces 236 of the OEs 230, e.g., as shown in FIG. 2. Grating couplers of the OEs 230 can be arranged to optically couple the OEs 230 with their respective optical fibers 270 in such examples. The grating couplers can respectively optically couple with fiber array units or connectors of the optical fibers 270. In one or more other examples, the optical fibers 270 can be edge coupled to respective side or edge surfaces 238 of the OEs 230. Optical waveguides of the photonic chips of the OEs 230 can be arranged to optically couple the OEs 230 with their respective optical fibers 270 in such examples. The optical waveguides can respectively optically couple with fiber array units or connectors of the optical fibers 270.

Electrical power can be provided to the IC 240 by way of a power channel 220 that traverses, at least in part, through the PCB 260 and, at least in part, through the substrate 210 between the first side 212 and the second side 214. The power channel 220 can be a lower speed channel than signal channels 218 that traverse, at least in part, through the substrate 210 between the first side 212 and the second side 214. In the example of FIG. 2, the portions of the signal channels 218 defined by the substrate 210 are directly electrically coupled with the SerDes 250 (there is no thin routing film in this example, unlike the example in FIG. 1A). The power channel 220 extends from the PCB 260 to the IC 240 and is arranged underneath the IC 240.

The architecture of the electro-optical assembly 200A can provide one or more advantages, benefits, and/or technical effects. For instance, by arranging the OEs 230 on an opposite side of the substrate 210 from the SerDes 250 and the IC 240, the length of the signal channels 218 can be minimized or reduced, which results in less transmission loss and increased signal integrity. Further, a size of the substrate 210 can be reduced or made smaller, which can lower the substrate cost and can increase substrate manufacturability/yield. Also, the cutouts 264 in the PCB 260 can provide clearance for the OEs 230 and feedthroughs for the optical fibers 270. Moreover, power delivery from the PCB 260 to IC 240 can occur directly from underneath the IC 240, which can allow for power to be delivered in an optimal way, and consequently, the substrate 210 can be formed less thick. In addition, this package configuration can allow for independent optimization of heat sinks for the IC 240/SerDes 250 and OEs 230 and the option to counterbalance the stress/warpage on the substrate 210.

FIG. 2B depicts a schematic side cross-sectional view of an electro-optical assembly 200B according to one or more aspects of the present disclosure. The electro-optical assembly 200B of FIG. 2B is configured in a same manner as the electro-optical assembly 200A of FIG. 2A described above, except as provided below.

As shown in FIG. 2B, in one or more examples, the OEs 230 can be directly attached to the second side 214 of the substrate 210 in a face-to-face manner, e.g., bonded face-to-face. Stated another way, the chipsets of the OEs 230 can be directly attached to the first side 212 of the substrate 210. Such a configuration can advantageously provide enhanced signal integrity and a more compact vertical profile of the package.

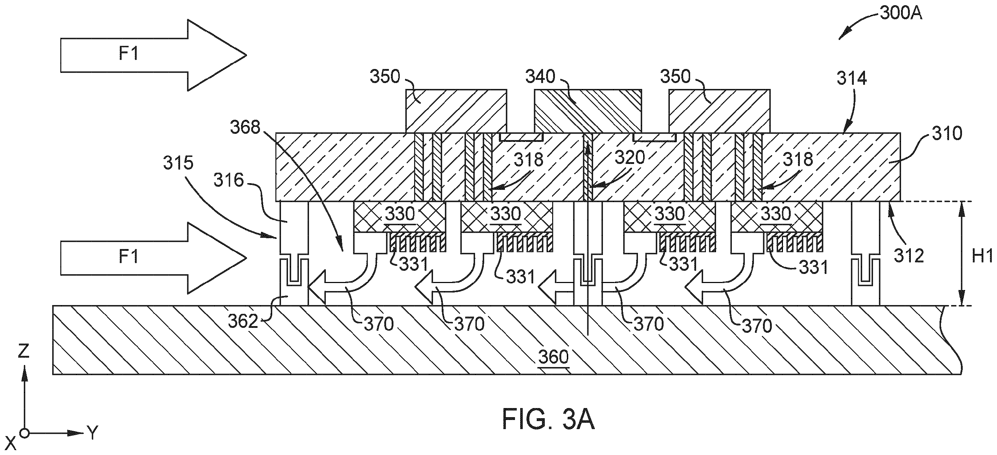

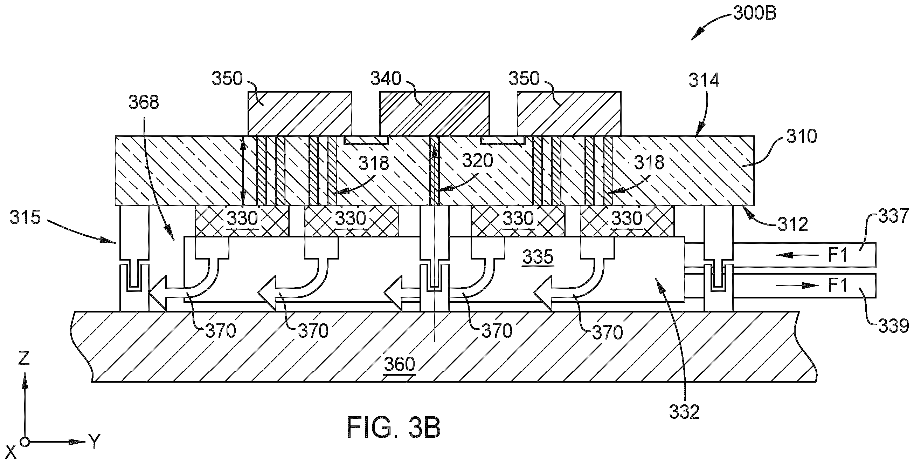

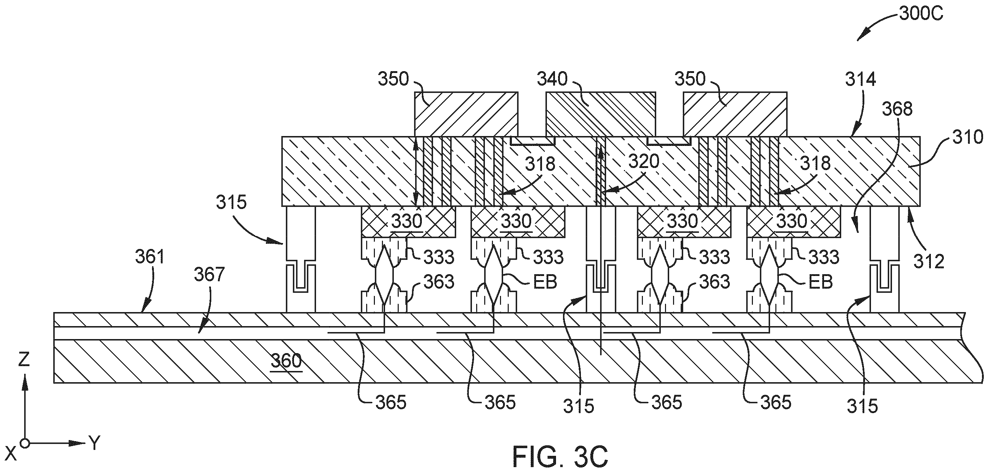

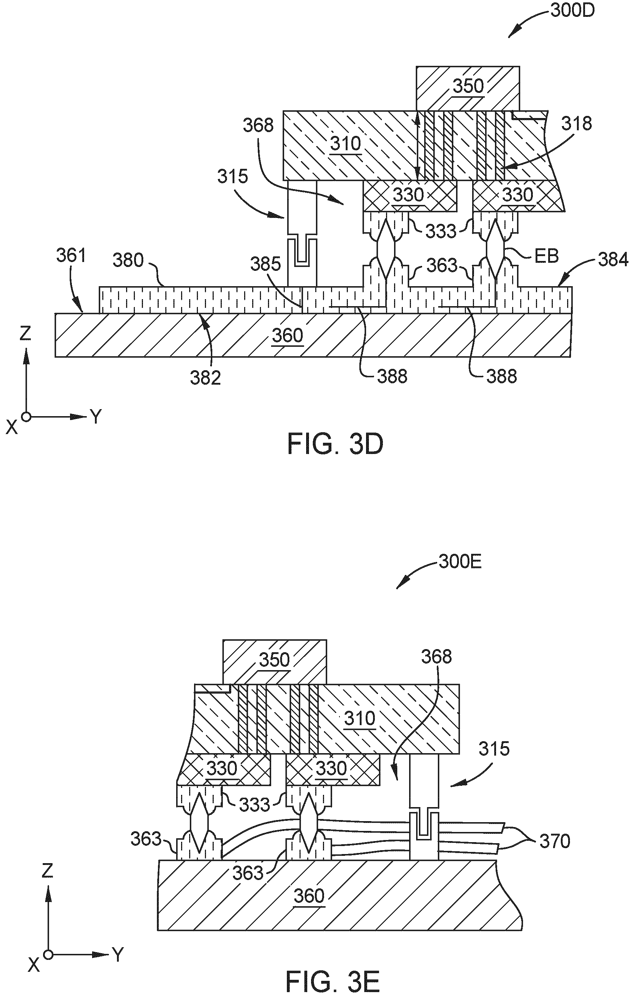

FIG. 3 depicts a schematic side cross-sectional view of an electro-optical assembly 300A according to one or more aspects of the present disclosure.

As shown in FIG. 3A, the electro-optical assembly 300A can include a substrate 310 having a first side 312 and a second side 314 opposing the first side 312. The first side 312 can be a bottom or back side and the second side 314 can be a top side. The electro-optical assembly 300A can also include OEs 330 coupled with the first side 312 of the substrate 310. In this example, the chipsets of the OEs 330 are attached directly to the second side 314, e.g., by bonding. The electro-optical assembly 300A can also include a plurality of SerDes 350 and an IC 340 coupled with the second side 314 of the substrate 310. The IC 340 can be electrically coupled with each of the SerDes 350, e.g., by electrical traces. The OEs 330 and the IC 340 and SerDes 350 are coupled with the substrate 310 on opposite sides. The IC 340 can be an NPU or other type of ASIC, for example. The electro-optical assembly 300A can further include a PCB 360 to which the substrate 310 is mounted by a plurality of interconnects 315. Each one of the interconnects can include mating structures 316 mounted to the substrate 310 and corresponding mating structures 362 mounted to the PCB 360. Optical fibers 370 can be optically coupled with the OEs 330. The optical fibers 370 can be surface coupled with the OEs 330, e.g., as shown in FIG. 3A, or in other examples, the optical fibers 370 can be edge coupled with the OEs 330.

The OEs 330 can be electrically coupled with the SerDes 350 by way of signal channels 318 that traverse, at least in part, through the substrate 310 between the first side 312 and the second side 314. The signal channels 318 can be high speed signal paths optimized for signal integrity, for example. In at least one example, each one of the OEs 330 is electrically coupled with at least one of the SerDes 350 by one or more of the signal channels 318. In one or more examples, electrical power can be supplied to the IC 340 by way of a power channel 320. The power channel 320 can be a lower speed channel than the signal channels 318. The power channel 320 can traverse, at least in part, through the substrate 310 between the first side 312 and the second side 314. The power channel 320 extends from the PCB 360 to the IC 340 and is arranged underneath the IC 340.

In depicted example of FIG. 3A, the PCB 360 is spaced vertically from the first side 312 of the substrate 310 to define an OE access clearance 368. In at least one example, the OE access clearance 368 can have a vertical dimension or height H1 of between about 5 millimeters and 10 millimeters, including the endpoints. In at least one example, the OE access clearance 368 can have a vertical dimension or height H1 that is at least as great as the vertical dimension or thickness of the substrate 310. In at least one example, the OE access clearance 368 can have a vertical dimension or height H1 such that the OEs 330 are spaced from the substrate 310 by a distance along the Z-direction that is at least twice the thickness of the thickest one of the OEs 330. In at least one example, the OE access clearance 368 can have a vertical dimension or height H1 such that the OEs 330 are spaced from the substrate 310 by a distance along the Z-direction that is at least the thickness of the thickest one of the OEs 330, e.g., as shown in FIG. 3A. The OE access clearance 368 can provide a clearance or space below the substrate 310 for the optical fibers 370 to access the OEs 330 and can also provide access for direct fluid flow to the OEs 330 for cooling.

In one or more examples, a fluid F1 can be directed to flow through or within the OE access clearance 368. In this example, the fluid F1 can be air. In one example, the fluid F1 can be forced through the OE access clearance 368, e.g., by way of a fan, blower, etc. In FIG. 3A, the fluid F1 is shown being forced in a left-to-right direction through the OE access clearance 368. A portion of the fluid F1 can flow above the substrate 310 as well, e.g., to cool the IC 340 and the SerDes 350. In one or more other examples, the fluid F1 can flow through the OE access clearance 368 by way of natural convection currents.

In one or more examples, the electro-optical assembly 300A can include one or more heat sinks 331 for enhancing the cooling of the OEs 330. As shown in FIG. 3A, each one of the OEs 330 can have an associated heat sink 331 coupled thereto. The heat sinks 331 can each be formed, at least in part, by a plurality of fins or fin arrays that are arranged in the OE access clearance 368. In one example, at least one of the heat sinks 331 can include a base plate from which the fins extend. The base plate can be attached to the photonic chip of its associated OE. In another example, at least one of the heat sinks 331 can include fins that extend directly from one of the chips of its associated OE, such as from the photonic chip. The heat sinks 331 can provide air-cooled heat sinks, e.g., with the fluid F1 passing through the OE access clearance 368 being air. The heat sinks 331 can be arranged to transfer heat generated by their respective OEs 330 to the fluid F1 flowing through the OE access clearance 368.

FIG. 3B depicts a schematic side cross-sectional view of an electro-optical assembly 300B according to one or more aspects of the present disclosure. The electro-optical assembly 300B of FIG. 3B is configured in a same manner as the electro-optical assembly 300A of FIG. 3A described above, except as provided below.

As shown in FIG. 3B, the electro-optical assembly 300B can include a liquid-cooled heat sink 332 arranged within the OE access clearance 368. The liquid-cooled heat sink 332 can include a casing 335 in which a liquid can flow, e.g., within one or more coils or in a reservoir. The casing 335 can be arranged to contact the OEs 330, as illustrated in FIG. 3B, or at least be positioned proximate the OEs 330 such that the OEs 330 are in a heat exchange relationship with the liquid-cooled heat sink 332. The casing 335 can be fluidly coupled with an inlet 337 and an outlet 339. A fluid F1 (e.g., a liquid, such as water) can be supplied to the casing 335 by way of the inlet 337 and heat given off by the OEs 330 can be imparted to the relatively cool fluid F1 flowing through the casing 335. The now relatively hot fluid F1 can exit the casing 335 by way of the outlet 339. In one or more examples, the fluid F1 can be forced through the liquid-cooled heat sink 332, e.g., by way of a pump. The liquid-cooled heat sink 332 can provide enhanced cooling to the OEs 330 and nearby components.

FIG. 3C depicts a schematic side cross-sectional view of an electro-optical assembly 300C according to one or more aspects of the present disclosure. The electro-optical assembly 300C is configured in a similar manner as the electro-optical assembly 300A of FIG. 3A, except as provided below.

For the electro-optical assembly 300C, the OEs 330 and the PCB 360 can each include features that enable coupling of optical signals between the OEs 330 and the PCB 360, e.g., by way of free space expanded beam (EBO) coupling. As shown in FIG. 3C, each one of the OEs 330 has an OE lens 333 coupled thereto. For instance, each one of the OEs 330 can include a photonic chip, and the OE lenses 333 can be attached to respective ones of the photonic chips. The PCB 360 can include a first PCB side 361 along which a plurality of PCB lenses 363 are arranged. The PCB lenses 363 can be arranged along the X-direction and the Y-direction so as to optically align with corresponding ones of the OE lenses 333. The PCB lenses 363 are optically coupled with respective optical waveguides 365 that traverse through an optical waveguide layer 367 of the PCB 360. The optical waveguide layer 367 can be spaced from the first PCB side 361, e.g., as shown in FIG. 3C.

Accordingly, optical signals can travel along the optical waveguides 365 embedded within the PCB 360, and can be directed from the PCB lenses 363 in expanded beam form to respective ones of the OE lenses 333. The expanded beams EB are depicted in FIG. 3C traveling between the PCB lenses 363 and the OE lenses 333. The OE lenses 333 can receive the optical signals and direct the received optical signals to the PIC of their respective OEs 330, e.g., for conversion into electrical signals that can be transmitted to the SerDes 350 by way of the signal channels 318, and then from the SerDes 350 to the IC 340. Signals can also be transmitted in an opposite direction along these signal paths, i.e., from the IC 340 to the optical waveguides 365. Advantageously, the EBO coupling enabled by the architecture of the electro-optical assembly 300C can compensate for minor lateral offsets between the substrate 310 and the PCB 360. Moreover, the optically-enabled PCB 360 can provide the optical waveguide layer 367 that can allow for incoming or outgoing optical signals to enter or leave the electro-optical assembly 300C at a remote optical coupling interface of the PCB 360 (remote with respect to the OEs 330), which can provide design flexibility to the package, among other benefits.

FIG. 3D depicts a schematic side cross-sectional view of a portion of an electro-optical assembly 300D according to one or more aspects of the present disclosure. The electro-optical assembly 300D is configured in a similar manner as the electro-optical assembly 300C of FIG. 3C, except as provided below.

As shown in FIG. 3D, the electro-optical assembly 300D can include an optical layer 380 disposed, at least in part, within the OE access clearance 368 and arranged on the PCB 360. The optical layer 380 can be formed of glass, for example. The optical layer 380 has a first layer side 382 and a second layer side 384 opposite the first layer side 382. The first layer side 382 of the optical layer 380 can be attached to the first PCB side 361 as illustrated in FIG. 3D. A plurality of optical layer lenses 386 can be arranged along the second layer side 384. The optical layer lenses 386 can be arranged along the X-direction and the Y-direction so as to optically align with corresponding ones of the OE lenses 333. The optical layer lenses 386 are optically coupled with respective optical waveguides 388 that traverse through the optical layer 380.

Accordingly, optical signals can travel along the optical waveguides 388 embedded within the optical layer 380, and can be directed from the optical layer lenses 386 in expanded beam form to respective ones of the OE lenses 333. The expanded beams EB are depicted in FIG. 3D traveling between the optical layer lenses 386 and the OE lenses 333. The OE lenses 333 can receive the optical signals and direct the received optical signals to the PIC of their respective OEs 330, e.g., for conversion into electrical signals that can be transmitted to the SerDes 350 by way of the signal channels 318, and then from the SerDes 350 to the IC (not depicted in FIG. 3D). Signals can also be transmitted in an opposite direction along these signal paths, i.e., from the IC to the optical waveguides 388. In one or more examples, an electrical trace 385 can extend through the optical layer 380 and electrically couple the PCB 360 with the interconnect 315. In this way, the substrate 310 can be electrically coupled with the PCB 360, e.g., for receiving electrical power.

Advantageously, the EBO coupling enabled by the architecture of the electro-optical assembly 300D can compensate for minor lateral offsets between the substrate 310 and the optical layer 380. Moreover, the optical layer 380 can allow for incoming or outgoing optical signals to enter or leave the electro-optical assembly 300D at a remote optical coupling interface of the PCB 360 (remote with respect to the OEs 330), which can provide design flexibility to the package, among other benefits. Moreover, with the architecture of the electro-optical assembly 300D, the PCB 360 does not need to be optically enabled.

FIG. 3E depicts a schematic side cross-sectional view of a portion of an electro-optical assembly 300E according to one or more aspects of the present disclosure. The electro-optical assembly 300E is configured in a similar manner as the electro-optical assembly 300C of FIG. 3C, except as provided below.

For the electro-optical assembly 300E of FIG. 3E, the OEs 330 can include OE lenses 333 coupled thereto and the PCB 360 can include PCB lenses 363 coupled thereto. The PCB lenses 363 can be arranged along the X-direction and the Y-direction so as to optically align with corresponding ones of the OE lenses 333. For this example, optical fibers 370 can be optically coupled with, and terminate at, respective ones of the PCB lenses 363.

Accordingly, optical signals can travel along the optical fibers 370, which can extend into the OE access clearance 368 and optically couple with the PCB lenses 363. The optical signals can travel from the optical fibers 370 to the PCB lenses 363 and can be directed from the PCB lenses 363 in expanded beam form to respective ones of the OE lenses 333. The expanded beams EB are depicted in FIG. 3E traveling between the PCB lenses 363 and the OE lenses 333. The OE lenses 333 can receive the optical signals and direct the received optical signals to the PIC of their respective OEs 330, e.g., for conversion into electrical signals that can be transmitted to the SerDes 350 by way of the signal channels 318, and then from the SerDes 350 to the IC (not depicted in FIG. 3E). Signals can also be transmitted in an opposite direction along these signal paths, i.e., from the IC to the optical fibers 370.

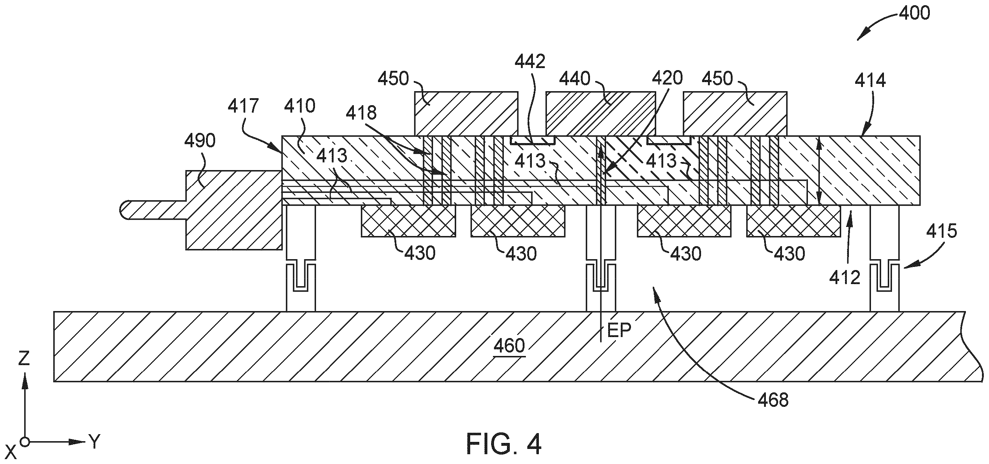

FIG. 4 depicts a schematic side cross-sectional view of an electro-optical assembly 400 according to one or more aspects of the present disclosure.

As shown in FIG. 4, the electro-optical assembly 400 can include a substrate 410 having a first side 412 and a second side 414 opposing the first side 412. The first side 412 can be a bottom or back side and the second side 414 can be a top side. The electro-optical assembly 400 can also include OEs 430 coupled with the first side 412 of the substrate 410. In this example, the chipsets of the OEs 430 are attached directly to the second side 414, e.g., by bonding. The electro-optical assembly 400 can also include a plurality of SerDes 450 and an IC 440 coupled with the second side 414 of the substrate 410. The IC 440 can be electrically coupled with each of the SerDes 450, e.g., by electrical traces 442. The OEs 430 and the IC 440/SerDes 450 are coupled with the substrate 410 on opposite sides. The IC 440 can be an NPU or other type of ASIC, for example. The electro-optical assembly 400 can further include a PCB 460 to which the substrate 410 is mounted by a plurality of interconnects 415. Each one of the interconnects 415 can include mating structures mounted to the substrate 410 and corresponding mating structures mounted to the PCB 360. The PCB 460 is spaced vertically from the first side 412 of the substrate 410 to define an OE access clearance 468.

The OEs 430 can be electrically coupled with the SerDes 450 by way of signal channels 418 that traverse, at least in part, through the substrate 410 between the first side 412 and the second side 414. The signal channels 418 can be high speed signal paths optimized for signal integrity, for example. In at least one example, each one of the OEs 430 is electrically coupled with at least one of the SerDes 450 by one or more of the signal channels 418. In one or more examples, electrical power EP can be supplied to the IC 440 by way of a power channel 420. The power channel 420 can be a lower speed channel than the signal channels 418. The power channel 420 can traverse, at least in part, through the substrate 410 between the first side 412 and the second side 414. The power channel 420 extends from the PCB 460 to the IC 440 and is arranged underneath the IC 440.

For the illustrated example of FIG. 4, the substrate 410 is a glass substrate having optical waveguides 413 optically coupling their respective OEs 430 and an optical connector 490 coupled with the substrate 410. The optical waveguides 413 can extend from their respective OEs 430 to a substrate edge 417 of the substrate 410. The optical connector 490 can be edge coupled with the substrate 410, e.g., as shown in FIG. 4, and can be optically coupled with the optical waveguides 413. In other examples, the optical waveguides 413 can extend from their respective OEs 430 to the second side 414 of the substrate 410 and the optical connector 490 can be surface coupled with the second side 414.

With the substrate 410 formed of glass, certain electrical benefits can be realized, such as improved signal integrity, improved routing density, and large aspect ratios can be facilitated. Moreover, the optically transparent nature of the glass can be leveraged to route optical signals, which can lead to larger density of the OEs 430, smaller assembly footprint and height, optical connectors can be supported as part of the package (leveraging channel aggregation in the substrate 410 and a larger mechanical interface at the substrate edge 417), and passive and/or active optical elements (e.g. demulitplexers, waveguide splitters, attenuators, etc.) can be offloaded into substrate 410, reducing the size of the OEs 430.

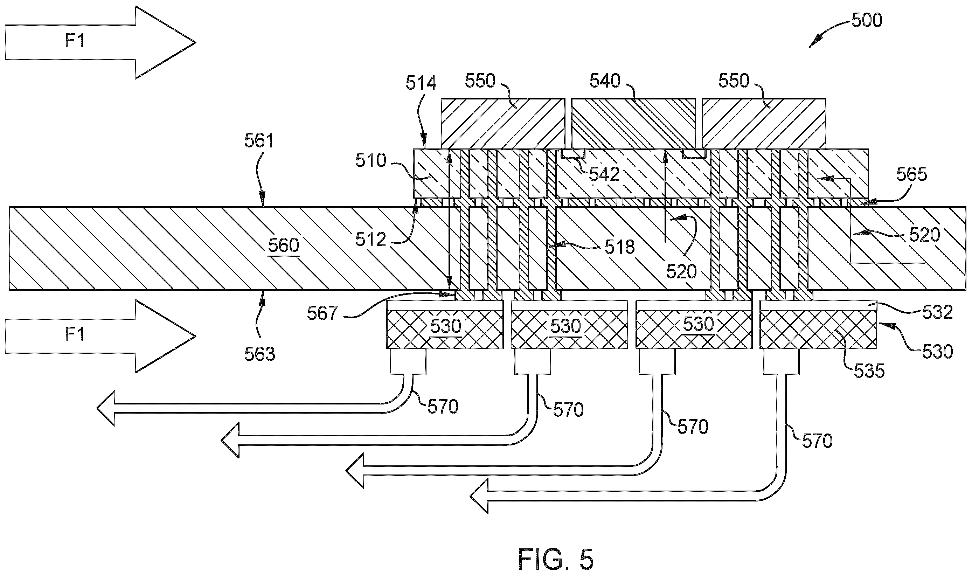

FIG. 5 depicts a schematic side cross-sectional view of an electro-optical assembly 500 according to one or more aspects of the present disclosure.

As shown in FIG. 5, the electro-optical assembly 500 can include a substrate 510 having a first side 512 and a second side 514 opposing the first side 512. The first side 512 can be a bottom or back side and the second side 514 can be a top side. The electro-optical assembly 500 can also include a plurality of SerDes 550 and an IC 540 coupled with the second side 514 of the substrate 510. The IC 540 can be electrically coupled with each of the SerDes 550, e.g., by electrical traces 542. The IC 540 can be an NPU or other type of ASIC, for example. The electro-optical assembly 500 can further include a PCB 560 having a first PCB side 561 and a second PCB side 563 opposing the first PCB side 561. The first PCB side 561 is coupled with the first side 512 of the substrate 510, e.g., by way of a ball grid array 565 having a plurality of soldered balls.

Furthermore, the electro-optical assembly 500 can include OEs 530 coupled with the second PCB side 563 of the PCB 560 (e.g., the backside of the PCB 560). In this regard, the PCB 560 can be arranged between the substrate 510 and the OEs 530, e.g., along the Z-direction. Each one of the OEs 530 can have a chipset 535 and an OE substrate 532 bonded to the chipset. The chipsets 535 can each include an electrical chip and a photonic chip. The electrical chip can be bonded to the OE substrate 532. The OE substrate 532 of each OE 530 can be coupled with the second PCB side 563, e.g., by way of a ball grid array 567 having a plurality of soldered balls. Moreover, optical fibers 570 can be coupled with respective ones of the OEs 530, e.g., to the photonic chips thereof. In at least one example, the optical fibers 570 can be surface coupled to respective bottom surfaces of the OEs 530, e.g., as shown in FIG. 5. In one or more other examples, the optical fibers 570 can be edge coupled to respective side surfaces of the OEs 530.

In one or more examples, the OEs 530 can be electrically coupled with the SerDes 550 by way of signal channels 518 that traverse, at least in part, through the PCB 560 between the first PCB side 561 and the second PCB side 563 and through the substrate 510 between the first side 512 and the second side 514. The signal channels 518 can be high speed signal paths optimized for signal integrity, for example. In at least one example, each one of the OEs 530 is electrically coupled with at least one of the SerDes 550 by one or more of the signal channels 518. In one or more examples, electrical power can be supplied to the IC 540 by way of one or more power channels 520. The power channels 520 can be lower speed channels than the signal channels 518. The power channels 520 can traverse, at least in part, through the substrate 510 between the first side 512 and the second side 514. The power channels 520 can extend from the PCB 560 to the IC 540 and at least one of the power channels 520 can be arranged underneath the IC 540.

In accordance with the architecture of the electro-optical assembly 500, the OEs 530 and the IC 540 and SerDes 550 are arranged on opposite sides of the substrate 510, and in addition, the OEs 530 and the IC 540 and SerDes 550 are arranged on opposite sides of the PCB 560. Such an architecture can allow for the substrate 510 to have a smaller footprint (or smaller dimension along the X-direction and/or the Y-direction) and thickness (or smaller dimension along the Z-direction). Also, a dens arrangement of the OEs 530 can be achieved since electrical power supplied to the IC 540 does not have to be delivered in between OEs 530. Further, heat sinking of the OEs 530 can be provided directly to the chassis bottom of the package, or by way of the flow of fluid F1 below the PCB 560, and/or by way of heat pipes reaching underneath the PCB 560.

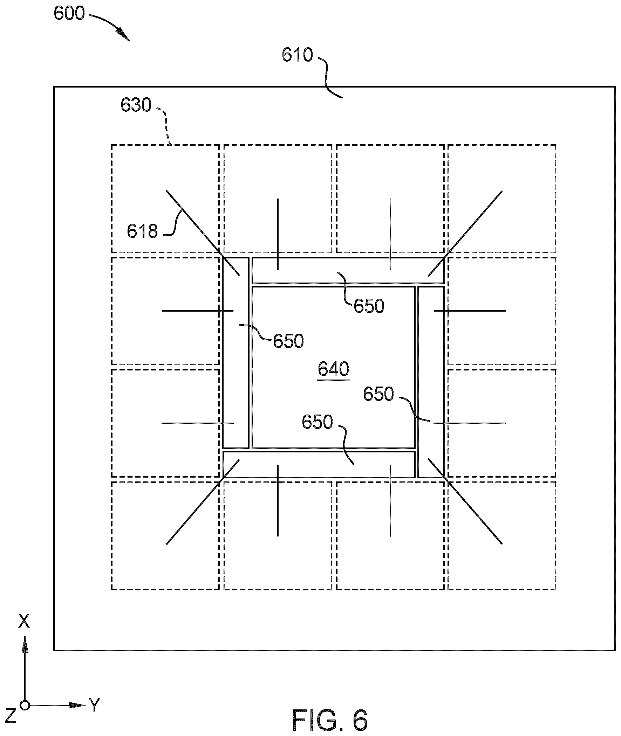

FIG. 6 depicts a schematic top view of an electro-optical assembly 600 according to one or more aspects of the present disclosure. The electro-optical assembly 600 can be a dual-sided CPO assembly, for example.

As depicted in FIG. 6, the electro-optical assembly 600 can include a substrate 610 to which a plurality of OEs 630 (twelve (12) shown in FIG. 6), an IC 640, and a plurality of SerDes 650 (four (4) shown in FIG. 6) are mounted. The IC 640 and SerDes 650 can be arranged on a same side of the substrate 610 opposite a side to which the OEs 630 are arranged. In FIG. 6, the OEs 630 are shown in dashed lines as they are mounted on a side of the substrate 610 opposite the IC 640/SerDes 650. The plurality of SerDes 650 circumscribe the IC 640. The plurality of OEs 630 circumscribe the SerDes 650 in a plane spaced from, but parallel to, a plane in which the plurality of SerDes 650 circumscribe the IC 640. Particularly, the OEs 630 can be arranged in a first horizontal plane (e.g., a first plane in the X- and Y-directions) and the IC 640 and the SerDes 650 can be arranged coplanar in a second horizontal plane (e.g., a second plane in the X- and Y-directions), with the first horizontal plane being spaced from (e.g., along the Z-direction), and parallel to, the second horizontal plane. With the architecture of the electro-optical assembly 600, the OEs 630 can be placed closer to the SerDes 650 so that the signals channels 618 (represented schematically in FIG. 6) are minimized, which can reduce loss and power dissipation and can increased signal integrity.

In the current disclosure, reference is made to various embodiments. However, the scope of the present disclosure is not limited to specific described embodiments. Instead, any combination of the described features and elements, whether related to different embodiments or not, is contemplated to implement and practice contemplated embodiments. Additionally, when elements of the embodiments are described in the form of "at least one of A and B," or "at least one of A or B," it will be understood that embodiments including element A exclusively, including element B exclusively, and including element A and B are each contemplated. Furthermore, although some embodiments disclosed herein may achieve advantages over other possible solutions or over the prior art, whether or not a particular advantage is achieved by a given embodiment is not limiting of the scope of the present disclosure. Thus, the aspects, features, embodiments and advantages disclosed herein are merely illustrative and are not considered elements or limitations of the appended claims except where explicitly recited in a claim(s).

In view of the foregoing, the scope of the present disclosure is determined by the claims that follow.

## Claims

1. An electro-optical assembly, comprising:
a substrate having a first side and a second side opposing the first side;
an optical engine, OE, coupled with the first side of the substrate;
a serializer/deserializer, SerDes, coupled with the second side of the substrate; and
an integrated circuit, IC, coupled with the second side of the substrate, the IC being electrically coupled with the SerDes,
wherein the OE is electrically coupled with the SerDes by way of a signal channel that traverses through the substrate between the first side and the second side.

2. The electro-optical assembly of claim 1, wherein the OE is arranged, at least in part, underneath the SerDes.

3. The electro-optical assembly of claim 1 or 2, wherein the signal channel has a length extending between the first side and the second side of the substrate, and wherein the signal channel extends substantially vertically along an entirety of the length.

4. The electro-optical assembly of any preceding claim, further comprising:
a thin routing film to which the SerDes and the IC are mounted, the thin routing film being arranged between the SerDes and the substrate and between the IC and the substrate, and wherein the thin routing film has an electrical trace electrically coupling the SerDes with the IC.

5. The electro-optical assembly of any preceding claim, further comprising:
a printed circuit board, PCB, to which the substrate is mounted, wherein the PCB defines a cutout in which the OE is disposed.

6. The electro-optical assembly of claim 5, wherein the first side is a back side of the substrate and the second side is a top side of the substrate, and wherein the electro-optical assembly further comprises:
an optical fiber coupled with the OE, the optical fiber extending through a bottom opening of the cutout and upward to the OE, optionally wherein one of:
A) the optical fiber is surface coupled to a bottom surface of the OE;
B) the optical fiber is edge coupled to an edge surface of the OE.

7. The electro-optical assembly of any preceding claim, wherein electrical power is provided to the IC by way of a power channel that traverses, at least in part, through the PCB and through the substrate between the first side and the second side, and wherein the power channel is a lower speed channel than the signal channel.

8. The electro-optical assembly of any preceding claim, wherein one or more of:
A) the OE has a chipset and an OE substrate, the OE substrate being attached to the chipset and bonded to the second side by way of one or more solder bumps;
B) the OE is directly attached to the second side of the substrate in a face-to-face manner.

9. The electro-optical assembly of any preceding claim, further comprising:
a printed circuit board, PCB, to which the substrate is mounted by a plurality of interconnects, the PCB being spaced vertically from the first side of the substrate to define an OE access clearance, optionally
further comprising a heat sink coupled with the OE, the heat sink being formed, at least in part, by fins arranged in the OE access clearance, further optionally
wherein the OE access clearance has a height of between 5 millimeters and 10 millimeters, including endpoints.

10. The electro-optical assembly of any preceding claim, further comprising:
a printed circuit board, PCB, to which the substrate is mounted by a plurality of interconnects, the PCB being spaced vertically from the first side of the substrate to define an OE access clearance, and wherein:
the OE has an OE lens, and
the PCB has an optical waveguide and a PCB lens that is spaced from, and optically coupled with, the OE lens, the PCB lens being optically coupled with the optical waveguide.

11. The electro-optical assembly of any preceding claim, further comprising:
a printed circuit board, PCB, to which the substrate is mounted by a plurality of interconnects, the PCB being spaced vertically from the first side of the substrate to define an OE access clearance; and
an optical layer disposed within the OE access clearance and arranged on the PCB, the optical layer has an optical waveguide and an optical layer lens that is optically coupled with an OE lens of the OE, the optical layer lens being optically coupled with the optical waveguide.

12. The electro-optical assembly of any preceding claim, further comprising:
a printed circuit board, PCB, to which the substrate is mounted by a plurality of interconnects, the PCB being spaced vertically from the first side of the substrate to define an OE access clearance, and wherein an optical fiber is coupled with a PCB lens arranged on the PCB within the OE access clearance, the PCB lens being optically coupled with an OE lens of the OE.

13. The electro-optical assembly of any preceding claim, wherein the substrate is a glass substrate having an optical waveguide optically coupling the OE and an optical connector coupled with the substrate.

14. An electro-optical assembly, comprising:
a printed circuit board, PCB;
a substrate mounted to the PCB;
an optical engine, OE;
a serializer/deserializer, SerDes; and
an integrated circuit, IC, electrically coupled with the SerDes,
wherein the IC and SerDes are arranged on a same side of the substrate opposite a side to which the OE is arranged, and wherein the OE is electrically coupled with the SerDes by way of a signal channel that traverses through the substrate and electrical power is supplied to the IC by way of a power channel that traverses from the PCB to the IC and extends through the substrate, and wherein the signal channel and the power channel are separate channels.

15. An electro-optical assembly, comprising:
a substrate having a first side and a second side opposing the first side;
a printed circuit board, PCB, having a first PCB side and a second PCB side opposing the first PCB side, the first PCB side being coupled with the first side of the substrate;
an optical engine, OE, coupled with the second PCB side, the PCB being arranged between the substrate and the OE;
a serializer/deserializer, SerDes, coupled with the second side of the substrate; and
an integrated circuit, IC, coupled with the second side of the substrate, the IC being electrically coupled with the SerDes,
wherein the OE is electrically coupled with the SerDes by way of a signal channel that traverses, at least in part, through the PCB between the first PCB side and the second PCB side and through the substrate between the first side and the second side.
